# FASCICULE DE BREVET EUROPEEN

(11) **EP 2 590 095 B1**
(45) Date de publication et mention de la délivrance du brevet: **22.05.2019**
(21) Numéro de dépôt: 12191646.4
(22) Date de dépôt: 07.11.2012
(51) Int. Cl.: G06F 17/50, E06B 9/32, E06B 9/56, E06B 9/68, G05D 23/20, G05D 25/02

(54) **Procédé de configuration et de fonctionnement d'une installation de protection solaire dans un bâtiment**
Konfigurations- und Funktionsverfahren einer Sonnenschutzanlage in einem Gebäude
Method for configuring and operating a solar protection facility in a building

(30) Priorité: 07.11.2011 FR 1160133
(43) Date de publication de la demande: 08.05.2013
(73) Titulaire: Somfy Activites SA, 74300 Cluses (FR)
(72) Inventeur: Roux, Morgan, 74190 Passy (FR); Neuman, Serge, 74600 Seynod (FR); Beaujeu, Thierry, 74970 Marignier (FR)
(74) Mandataire: Novaimo

(56) Documents cités:
- EP-A2- 2 357 544
- WO-A2-2009/056144
- US-A- 4 457 296
- US-A1- 2010 288 264

## Description

L'invention concerne le domaine du bâtiment et plus particulièrement des façades dites dynamiques, comportant des écrans motorisés de protection solaire, mobiles et ajustables.

Le document EP2357544 décrit un procédé de fonctionnement d'une couverture d'une ouverture d'un bâtiment, la couverture étant déplacée de sorte à limiter les consommations d'énergie. Des capteurs (ensoleillement ou température) et une mesure effectuée en temps réel sont utilisés pour mettre en oeuvre un tel procédé.

Le document US4457296 décrit un dispositif de support et de guidage d'une source de lumière électrique permettant une simulation de l'éclairement lumineux naturel sur des maquettes de constructions. L'objectif est l'étude de l'éclairement lumineux naturel et des ombres portées par les éléments présents sur la maquette, notamment pour différentes maquettes et en différentes zones géographiques en utilisant une simulation à partir d'une maquette réelle. L'étude vise à optimiser la construction ou l'emplacement d'un bâtiment, ainsi que le placement d'éléments fixes, comme des pare-soleils (sun shades), arbres, avant-toits, qui vont créer des zones d'ombres sur les fenêtres et les murs du bâtiment.

Les façades dynamiques permettent d'assurer le confort lumineux dans le bâtiment et de réaliser des économies en énergie en régulant les flux énergétiques (apports thermiques et ventilation naturelle) à travers les ouvertures de la façade. Les écrans peuvent être des stores d'intérieur, par exemple des stores vénitiens à lames orientables, ou des stores enroulables, ou des écrans extérieurs, des panneaux rigides orientables, etc. Plusieurs écrans peuvent être situés au niveau d'une même ouverture.

Au niveau de chaque ouverture équipée d'un ou plusieurs écrans, des actionneurs pilotent le mouvement de ces écrans mobiles en rotation et/ou en translation. Les actionneurs sont gérés de manière centrale au niveau de la pièce, de l'étage, de la façade à laquelle ils appartiennent ou simplement au niveau du bâtiment. Une unité de commande récupère également un certain nombre d'informations auprès de divers capteurs positionnés à l'intérieur et à l'extérieur du bâtiment (capteurs de présence, de température, de luminosité, etc.).

Chaque actionneur peut également être piloté individuellement ou dans un groupe par l'intermédiaire d'un point de commande locale. En particulier, des zones de contrôle sur une même façade peuvent être définies. Sur l'ensemble de chaque zone, les actionneurs seront contrôlés simultanément par l'unité de commande centrale. Une zone peut également correspondre à la totalité d'une façade ou même du bâtiment.

Cependant, il existe un besoin de contrôle plus fin, notamment fenêtre par fenêtre, pour tenir compte de conditions locales, par exemple les ombres portées sur le bâtiment, par une autre partie du bâtiment ou par des éléments environnants, comme d'autres bâtiments ou des reliefs géographiques. Diverses solutions de gestion des ombres portées existent. Elles nécessitent généralement une procédure complexe pour la configuration du dispositif de gestion et ne peuvent être ajoutées à des installations existantes. L'invention vise donc à apporter des solutions aux problèmes précités.

En particulier, le procédé de configuration et le procédé de fonctionnement de l'installation selon la présente invention présentent une souplesse et une simplicité d'utilisation supérieure aux procédés existants. Par ailleurs, l'installation peut présenter des moyens de calcul de puissance faible pour la gestion des ombres portées, ce qui en diminue grandement le coût. Par ailleurs, l'invention permet une évolutivité satisfaisante.

Le but de l'invention est de fournir un procédé de configuration et un procédé de fonctionnement d'une installation remédiant aux inconvénients mentionnés et améliorant les procédés connus de l'art antérieur. En particulier, l'invention propose un procédé de configuration d'une installation et une installation, définis dans les revendications indépendantes, permettant une gestion simple et économique des ombres portées sur une façade ou un bâtiment.

Selon un exemple pertinent le procédé permet de configurer une installation de protection solaire dans un bâtiment. L'installation comprend une unité centrale de commande, des écrans motorisés de protection solaire équipant des ouvertures du bâtiment. Le procédé comprend :
i. Une étape de modélisation du bâtiment et des ouvertures sur des façades du bâtiment,
ii. Une étape de détermination itérative des ombres portées par le bâtiment sur lui-même et/ou par les structures environnantes également modélisées en fonction du temps et pour une localisation géographique du bâtiment donnée,
iii. Une étape de génération d'un fichier de configuration comprenant des données représentant la présence ou non d'une ombre portée sur chaque ouverture équipée par un écran motorisé de protection solaire en fonction du temps,
iv. Une étape de fourniture du fichier de configuration à l'unité centrale de commande de l'installation.

La modélisation lors de l'étape (i) peut être une modélisation virtuelle en trois dimensions du bâtiment, incluant la localisation des façades et le positionnement des ouvertures équipées d'écrans motorisés de protection solaire sur les façades.

Le procédé peut comprendre une étape de modélisation virtuelle en trois dimensions des structures et reliefs environnants le bâtiment.

Les données du fichier de configuration peuvent être des données binaires indiquant ou non la présence d'une ombre portée pour une ouverture donnée ou une partie d'ouverture donnée, à un instant donné.

L'étape (ii) peut être réalisée par façade et réitérée pour chaque façade du bâtiment pour lesquelles une information de présence de soleil est fournie.

L'étape (ii) de détermination itérative peut avoir lieu par incrément de temps sur la totalité d'une année calendaire.

Les étapes (ii), (iii), (iv) peuvent être réitérées si un changement est intervenu sur le bâtiment ou sur son environnement nécessitant une mise à jour du fichier de configuration.

Le fichier de configuration peut contenir des informations relatives à l'ombre portée sur une partie de chaque ouverture.

Selon un exemple pertinent un procédé régit le fonctionnement d'une installation comprenant une unité centrale de commande et des écrans motorisés de protection solaire. Le procédé de fonctionnement comprend une étape d'utilisation du fichier de configuration généré par mise en oeuvre du procédé de configuration défini précédemment pour commander les écrans motorisés, notamment une étape d'utilisation d'un fichier de configuration généré par mise en oeuvre du procédé de configuration défini précédemment et comprenant des données représentant la présence ou non d'ombres portées sur chaque ouverture équipée par un écran motorisé de protection solaire en fonction du temps. Alternativement, le procédé de fonctionnement comprend :
- une étape de génération d'un fichier de configuration comprenant des données représentant la présence ou non d'une ombre portée sur chaque ouverture équipée par un écran motorisé de protection solaire en fonction du temps, notamment une étape de mise en oeuvre du procédé de configuration défini précédemment, et
- une étape d'utilisation du fichier de configuration.

L'étape d'utilisation du fichier peut comprendre :
v. Une étape de commande de mouvement de chaque écran motorisé de protection solaire d'une première zone de façade en fonction d'une information de présence de soleil relative à la première zone de façade,
vi. Une étape d'inhibition de la commande de mouvement de l'étape précédente en fonction des données du fichier de configuration relatives à chaque ouverture de la zone.

Les données du fichier de configuration peuvent être fournies sélectivement au cours du temps au niveau d'une entrée d'un actionneur, d'un groupe d'actionneur ou d'un moyen de commande local d'un ou plusieurs actionneurs de manoeuvre d'écran motorisé.

L'étape d'inhibition peut dépendre d'une information de niveau d'ensoleillement.

Selon un exemple pertinent un support de données, notamment un support de données lisible par un ordinateur ou un calculateur, comprend un fichier de configuration :
- obtenu par mise en oeuvre du procédé de configuration défini précédemment ; et/ou
- contenant des données et issu d'une modélisation d'un bâtiment et des ouvertures sur des façades du bâtiment, d'une détermination itérative de l'ombre portée par le bâtiment sur lui-même et/ou par les structures environnantes également modélisées en fonction du temps et pour une localisation géographique du bâtiment donnée, les données représentant la présence ou non d'une ombre portée sur chaque ouverture ou chaque partie d'une ouverture équipée par un écran motorisé de protection solaire en fonction du temps.

Selon un exemple pertinent une installation de protection solaire dans un bâtiment muni d'ouvertures, comprend une unité centrale de commande, des écrans motorisés de protection solaire, l'unité centrale de commande étant adaptée à fournir des ordres de commande de mouvement de chaque écran motorisé de protection solaire d'une première zone de façade en fonction d'une information de présence de soleil relative à la première zone de façade et comprenant une mémoire destinée à stocker un fichier de configuration comprenant des données relatives à la présence ou non d'une ombre portée sur chaque ouverture équipée par un écran motorisé de protection solaire en fonction du temps. L'installation comprend également une entrée correspondant à chaque écran motorisé ou chaque moyen de commande local pilotant un ou plusieurs écrans motorisés et des moyens matériels et/ou logiciels pour inhiber une commande de mouvement reçue par un écran motorisé lorsque la donnée fournie en entrée d'un écran motorisé indique la présence d'une ombre portée sur l'ouverture ou la partie d'ouverture correspondant à cet écran.

L'invention sera mieux comprise à la lecture de la description qui va suivre, donnée uniquement à titre d'exemple et faite en se référant aux dessins annexés sur lesquels :
La figure 1 représente un bâtiment dans lequel un procédé de configuration et un procédé de fonctionnement selon l'invention sont mis en oeuvre.
La figure 2 représente une installation immotique dans laquelle un procédé de configuration selon l'invention peut être mis en oeuvre.
La figure 3 représente un ordinogramme d'un premier mode d'exécution d'un procédé de configuration selon l'invention.
La figure 4 représente un ordinogramme d'un premier mode d'exécution d'un procédé de fonctionnement selon l'invention.

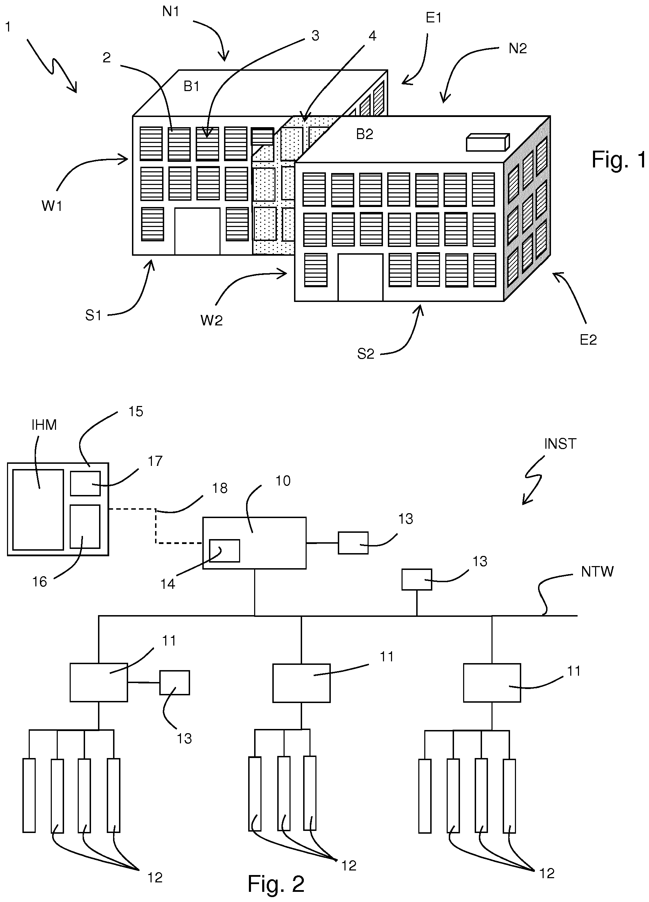

La figure 1 représente un bâtiment 1, par exemple de type tertiaire, en deux parties B1 et B2, à usage de bureaux par exemple. Les deux parties du bâtiment comprennent une pluralité d'ouvertures 2 (notamment des fenêtres) disposées sur des façades S1, S2, E1, E2, N1, N2, W1, W2 (ces quatre dernières façades étant cachées) orientées au Sud, Est, Nord, Ouest. Les ouvertures sont équipées d'écrans mobiles motorisés 3, notamment des écrans de fermeture, d'occultation ou de protection solaire, une partie de ceux-ci étant représentée en position fermée par des hachures horizontales sur les façades S1, S2, E1 et E2.

Une ombre portée sur la façade S1 de la première partie du bâtiment par la deuxième partie du bâtiment est représentée par une zone grisée 4. Le reste des façades visibles est exposé au soleil. Les écrans des ouvertures situées dans la zone d'ombre sont relevés, tandis que les écrans des ouvertures situées au soleil sont baissés de manière à respecter l'exposition propre à chaque ouverture, plutôt que par zone prédéfinie à l'avance au niveau d'une unité de commande centrale.

Une installation automatisée INST, représentée en figure 2, permet la gestion dynamique des façades du bâtiment.

Les écrans de protection solaire mobiles sont chacun pilotés par un actionneur 12, ce dernier permettant l'ouverture et la fermeture automatisée de l'écran. Les actionneurs sont généralement masqués dans des rails ou des caissons lorsqu'ils sont installés et sont alors difficilement accessibles par l'intérieur ou l'extérieur du bâtiment.

L'automatisation de l'installation du bâtiment, notamment des écrans via leurs actionneurs 12, basée sur la présence d'une unité de commande centrale 10, de moyen de commandes locaux 11 et de capteurs divers 13 (présence, luminosité, température, etc), permet de gérer notamment le confort et la thermique dans le bâtiment. Pour cela, les différents équipements (actionneurs, moyens de commande, capteurs) communiquent entre eux par le biais de réseaux NTW sans fil (radio notamment) ou filaires (bus câblés, courants porteurs). Un exemple d'installation est représenté en figure 2.

Le terme d'actionneur utilisé dans cette demande comprend notamment la partie électronique ou électromécanique permettant le contrôle du mouvement de l'écran ou le contrôle d'état d'une charge, par exemple d'une lampe, mais également les moyens électroniques de dialogue avec les différents autres équipements de l'installation, notamment les dispositifs d'émission et de réception de trames de communication échangées entre les différents composants de l'installation selon des moyens connus.

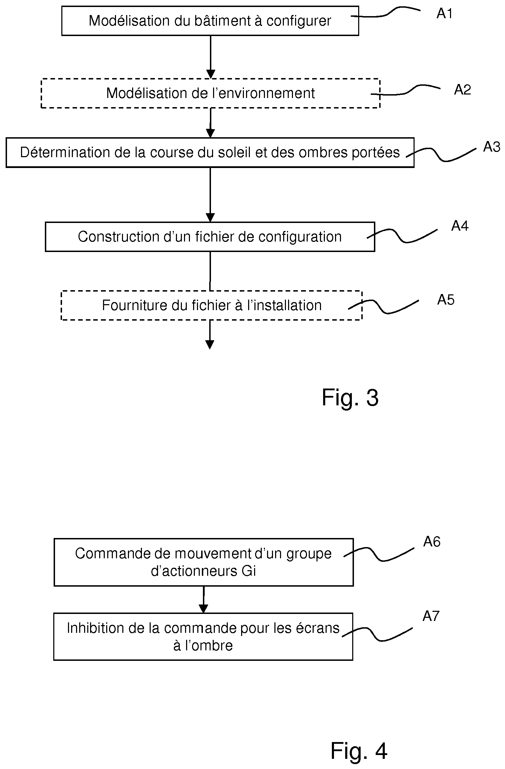

Un premier mode de réalisation simple du procédé de configuration selon l'invention est décrit ci-après en référence à la figure 3. Il est mis en oeuvre par un dispositif de configuration 15 comprenant des moyens informatiques, notamment une interface IHM (écran et moyens d'interaction avec celui-ci, par exemple un clavier, une souris et/ou un panneau tactile), des moyens de calcul 16, comme une unité logique de traitement, et des moyens 17 de réception et de transmission d'informations, par exemple par une liaison Internet. Le dispositif de configuration 15 peut être un ordinateur, notamment de type PC, un assistant numérique ou un outil spécifiquement dédié à la configuration d'une telle installation. Il se raccorde à l'installation directement ou par l'intermédiaire d'un des moyens de commande, par voie filaire ou non filaire. Cette connexion 18 est représentée sous la forme d'un trait pointillé, elle peut être temporaire.

Au cours d'une étape A1 du procédé de configuration, on met en oeuvre une étape de modélisation du bâtiment, notamment une modélisation du bâtiment en trois dimensions et une modélisation des écrans motorisés de protection solaire sur les différentes façades du bâtiment. La modélisation peut comprendre une construction graphique ou une simple identification, par exemple une identification des ouvertures concernées par l'invention. L'utilisation d'un logiciel spécifique dédié à la représentation virtuelle d'une forme en trois dimensions est particulièrement adaptée pour cette étape. En particulier, les dimensions réelles et le positionnement précis des ouvertures destinées à recevoir des écrans motorisés doivent être respectées au cours de l'étape A1. De préférence, cette modélisation prendra appui sur des plans de construction du bâtiment, voire sur une modélisation fournie par l'architecte en charge de la construction du bâtiment. Des outils de visualisation de l'environnement (de type géoportail ou Google Earth TM) pourront également servir de support à la modélisation du bâtiment concerné. Au cours de cette étape, on saisit ou on récupère donc des données relatives à la géométrie du bâtiment ainsi que des données relatives à l'orientation géographique et à la position géographique du bâtiment.

Au cours d'une étape A2 optionnelle, les structures environnantes sont également modélisées et éventuellement insérées sur la même interface graphique que la modélisation du bâtiment automatisé. Les structures environnantes peuvent être d'autres bâtiments, des reliefs géologiques ou naturels. En particulier dans le cas de reliefs naturels, comme des arbres, une évolution prévisionnelle de la dimension future de ces reliefs peut être intégrée lors de cette étape A2. Au cours de cette étape, on saisit ou on récupère donc des données relatives à la géométrie des structures environnantes ainsi que des données relatives aux positions des structures environnantes relativement au bâtiment.

La modélisation peut être réalisée sous forme d'un maillage de points ou d'objets.

Dans les deux étapes A1 et A2, il est également possible de ne pas modéliser graphiquement le bâtiment, mais de fournir les coordonnées des différents points du maillage pour permettre de calculer la présence de soleil ou d'ombres pour chaque point du maillage du bâtiment au cours du temps.

Puis au cours d'une troisième étape A3, on détermine, par exemple itérativement, les ombres portées sur le bâtiment. Cette notion de détermination itérative porte sur le fait de réunir par écran et par incréments de temps des données relatives à l'ensemble du bâtiment.

L'ombre portée peut être, comme expliqué précédemment, l'ombre portée par le bâtiment sur lui-même et/ou par les structures environnantes, notamment les structures modélisées au cours de l'étape A2. De manière alternative ou complémentaire, les reflets sur le bâtiment, dus aux structures environnantes peuvent également être modélisés, les reflets étant fonction de la nature ou de la couleur des matériaux constituant les structures environnantes, notamment les façades des structures environnantes.

La détermination itérative est réalisée par une simulation de la course du soleil au cours du temps, par exemple une évaluation des trajectoires des rayons lumineux, et en tenant compte de l'impact des structures se trouvant sur les trajectoires des rayons de soleil simulés. Cette détermination itérative est réalisée pour une localisation géographique du bâtiment donnée (latitude, longitude et orientation des façades), cette information étant fournie par exemple lors de l'étape A1 de modélisation du bâtiment. La détermination itérative peut être réalisée de manière graphique également avec représentation des ombres portées sur le bâtiment au cours du temps.

Préférentiellement, des incréments de temps sont choisis pour cette étape, par exemple une détermination des ombres portées toutes les 15 minutes. La détermination itérative a alors lieu par incréments de temps sur la totalité d'une année calendaire.

L'étape précédente permet de générer un fichier de configuration, comprenant des données représentant la présence ou non d'une ombre portée sur chaque ouverture équipée par un écran motorisé de protection solaire en fonction du temps, au cours d'une étape de calcul A4. Le calcul est mis en oeuvre par les moyens de calcul du dispositif de configuration, sur la base d'un logiciel spécifiquement mis en oeuvre pour cette étape. Le logiciel permet en effet de rapporter, à chaque ouverture représentée, la détermination de la présence ou non d'une ombre portée au cours du temps et d'enregistrer ces données dans le fichier de configuration. Par exemple, le fichier peut comprendre une matrice comprenant des identifiants d'ouverture en lignes et les différentes dates de l'année en colonnes. Par « date », on entend instant défini par une heure donnée un jour donné de l'année, par exemple 28 janvier 16h15. En choisissant un pas de temps de 15 minutes, on obtient 24x4x365=35040 dates dans une année de 365 jours. Dans cette matrice, on peut représenter par une valeur donnée, par exemple un « 1 », la présence d'une ombre à une date donnée au niveau d'une ouverture donnée. On peut représenter par une valeur donnée, par exemple un « 0 », l'absence d'une ombre à une date donnée au niveau d'une ouverture donnée. La présence de rayonnement non direct, c'est-à-dire réfléchi au niveau d'une ouverture peut être déterminée par une autre valeur, par exemple « 0.5 ». Cette valeur peut aussi dépendre de l'intensité du rayonnement réfléchi. Dans ce cas, on peut, lors de l'utilisation des données, fixer un seuil et considérer chaque valeur comme égale à « 1 » si elle est supérieure à ce seuil ou comme égale à « 0 » si elle est inférieure ou égale à ce seuil. On peut encore traiter autrement les valeurs.

Enfin, une cinquième étape A5 clôt le procédé de configuration. Au cours de cette étape, le fichier de configuration établi lors de l'étape précédente est fourni à l'unité centrale de commande de l'installation associée au bâtiment qui a fait l'objet de la configuration.

Selon un mode de réalisation préféré, la modélisation lors de l'étape A1 et/ou de l'étape A2 est une modélisation graphique et/ou virtuelle en trois dimensions du bâtiment concerné par la configuration et éventuellement du ou des bâtiments environnants, incluant la localisation des façades et le positionnement des ouvertures équipées d'écrans motorisés de protection solaire sur les façades, ou des reliefs environnants le bâtiment concerné. Cette représentation virtuelle en trois dimensions permet de visualiser la présence des ombres portées à un instant donné pour la localisation précise du bâtiment concerné par la configuration, ainsi que de faire varier celle-ci en créant une animation virtuelle par succession d'images à des instants différents.

Alternativement, la représentation graphique pourrait également être en deux dimensions, avec une représentation façade par façade et une reconstruction du bâtiment virtuel uniquement par calcul, sans représentation graphique. Les coordonnées et expositions des façades devraient alors être clairement renseignées pour le bon déroulement du procédé de configuration. La détermination itérative de l'étape A3 serait alors uniquement sous forme de calcul. La représentation virtuelle du bâtiment ne pourrait faire l'objet d'une animation visuelle que sur chaque façade. Les étapes de calcul peuvent être réitérées pour chaque zone de façade ou façade du bâtiment pour lesquelles une information de présence de soleil est fournie.

Le procédé de configuration peut être renouvelé pour un bâtiment au cours du temps si un changement est intervenu sur le bâtiment (par exemple une modification de la structure ou un changement dans l'installation) ou sur son environnement nécessitant une mise à jour du fichier de configuration. C'est par exemple le cas si un nouveau bâtiment est construit à proximité du bâtiment concerné. C'est encore le cas si la végétation s'est développée à proximité du bâtiment concerné. Cette maintenance est alors plus simple que pour une première configuration si les données de modélisation d'origine ont été conservées. En particulier, l'étape de modélisation du bâtiment peut ne plus être nécessaire, seule l'étape de modélisation de l'environnement, notamment d'un bâtiment environnant, étant alors à mettre en oeuvre.

Selon un mode de réalisation de l'invention, les données du fichier de configuration sont des données binaires (1, 0) indiquant ou non la présence d'une ombre portée pour une ouverture donnée à un instant donné. Ces données peuvent alors être fournies sous forme d'un fichier de tableur, par exemple Excel, à l'unité centrale de commande de l'installation.

Une fois le procédé de configuration terminé, l'installation est prête à mettre en oeuvre un fonctionnement de l'installation tenant compte de la présence d'ombres portées, en particulier avec une gestion ouverture par ouverture. Les données du fichier de configuration peuvent être exploitées directement par l'unité centrale de commande, notamment par transmission vers une entrée spécifique (par exemple une entrée marche/arrêt ou écran activé/écran désactivé prioritaire) en lien avec chaque actionneur ou chaque moyen de commande local pilotant un ou plusieurs actionneurs. Cette réalisation est particulièrement simple lorsque les données du fichier de configuration sont des données binaires. Alternativement, l'unité centrale de commande traduit si nécessaire tout ou partie du fichier de configuration pour le rendre exploitable par une entrée disponible et prioritaire en lien avec chaque actionneur ou chaque moyen de commande local pilotant un ou plusieurs actionneurs.

En fonctionnement, lorsque l'installation reçoit une information de présence de soleil relative à la première zone de façade, elle met en oeuvre une première étape A6 de commande de mouvement de chaque écran motorisé de protection solaire de la première zone de façade pour positionner les écrans en position fermée. Selon le procédé de l'invention, il est aussi mis en oeuvre une étape de commande de mouvement pour positionner des écrans en position ouverte pour les ouvertures se trouvant à l'ombre. Ceci peut être réalisé par une étape inhibition A7 d'inhibition de la commande de mouvement de l'étape A6 pour un ou plusieurs écrans de cette première zone de façade, c'est-à-dire que la commande n'est pas exécutée par les écrans motorisés concernés, si l'information issue du fichier de configuration correspond à la présence d'une ombre portée sur cette ou ces ouvertures associées à cet écran motorisé ou à ces écrans motorisés.

Dans ce cas, les écrans motorisés de la première zone de façade exécutent l'ordre de commande, c'est-à-dire notamment les écrans sont baissées pour permettre une régulation des entrées lumineuses à l'intérieur du bâtiment, à part celui ou ceux pour lesquels une ombre portée est déterminée. Il est possible de prévoir que, dans un fonctionnement inverse, par exemple en hiver et en l'absence de personnes dans le bâtiment, l'ordre de commande sur détection de présence de soleil est un ordre de remontée des stores, pour bénéficier au contraire des apports calorifiques. Le ou les écrans concernés par la présence d'une ombre portée peuvent ainsi rester dans leur configuration initiale, par exemple ils peuvent être maintenus baissés. La commande de mouvement est alors également inhibée.

Selon un mode de réalisation de l'invention, les données du fichier sont fournies directement, notamment lorsqu'il s'agit de données binaires ou indirectement (les données étant alors interprétées), sélectivement au cours du temps au niveau d'une entrée d'un actionneur, d'un groupe d'actionneur ou d'un moyen de commande local d'un ou plusieurs actionneurs de manoeuvre d'écran motorisé. L'actionneur lui-même, ou le moyen de commande local inhibe au cas par cas les ordres reçus par l'unité centrale de commande.

Selon un mode de réalisation alternatif, l'unité centrale de commande traite les informations issues du fichier de configuration et émet sélectivement des ordres de commande uniquement à l'attention des écrans faisant l'objet d'un ensoleillement. Dans les deux cas, la commande de mouvement associée à l'information de présence de soleil sur la première zone de façade est dite inhibée pour les écrans concernés par la présence d'ombres portées.

Une nouvelle commande de mouvement est transmise vers les écrans motorisés en cas de besoin, c'est-à-dire notamment soit parce que le soleil n'est plus présent (l'information de présence de soleil disparaît) ou parce que les données du fichier indiquent une modification, du fait du temps écoulé, sur les présences d'ombres portées sur les différentes ouvertures de la première zone de façade. L'unité centrale de commande vérifie donc régulièrement la cohérence entre les informations de présence de soleil et de présence d'ombres portées. Préférentiellement, le fichier de configuration est préalablement établi en tenant compte de la fréquence de vérification opérée par l'unité centrale de commande.

Le contrôle des écrans motorisés de l'installation tenant compte de la présence d'ombres portées est donc indépendant d'un contrôle évolué de la position et de l'angle du soleil en temps réel. Un capteur d'ensoleillement fournissant une information de présence ou d'absence de soleil, ou plus généralement une information de niveau d'ensoleillement, peut être suffisant pour permettre le contrôle précis selon l'invention.

De manière plus fine, il est envisageable que le fichier de configuration fournisse des informations liées à des parties d'ouvertures. Ainsi des positions intermédiaires dans lesquelles positionner les écrans lorsque seule une partie de l'ouverture est couverte par une ombre portée par le bâtiment ou son environnement pourraient être déterminées. L'inhibition de commande concernerait alors une inhibition partielle, un mouvement étant autorisé sur une partie de la course d'un écran et bloqué sur une autre partie.

L'invention concerne également un support de données, étant apte à stocker notamment un fichier de configuration issu de la modélisation d'un bâtiment et des écrans motorisés de protection solaire sur les façades du bâtiment, de la détermination itérative des ombres portées par le bâtiment sur lui-même et/ou par les structures environnantes également modélisées en fonction du temps, pour une localisation géographique du bâtiment donnée, les données représentant la présence ou non d'une ombre portée sur chaque ouverture équipée par un écran motorisé de protection solaire en fonction du temps.

L'invention concerne également une installation de protection solaire dans un bâtiment, notamment du type représentée à la figure 2, comprenant une unité centrale de commande, des écrans motorisés de protection solaire, l'unité centrale de commande étant adaptée à fournir des ordres de commande de mouvement de chaque écran motorisé de protection solaire d'une première zone de façade en fonction d'une information de présence de soleil relative à la première zone de façade et comprenant une mémoire destinée à stocker un fichier de configuration comprenant des données relatives à la présence ou non d'une ombre portée sur chaque ouverture équipée par un écran motorisé de protection solaire en fonction du temps, l'installation comprenant également une entrée correspondant à chaque écran motorisé ou à chaque moyen de commande local et les moyens matériels et logiciels pour inhiber une commande de mouvement reçue par un écran motorisé lorsque la donnée fournie en entrée d'un écran motorisé indique la présence d'une ombre portée sur l'ouverture associée à cet écran. Cette entrée d'information peut être une entrée d'information située au niveau du moyen de commande local ou de l'actionneur, ou au niveau de l'unité centrale de commande.

Dans les revendications qui suivent, le terme « temps » a un sens chronologique et non un sens météorologique.

## Revendications

1. Procédé mis en oeuvre par ordinateur de configuration d'une installation (INST) de protection solaire dans un bâtiment (1), l'installation comprenant une unité centrale de commande (10) de mouvement d'écrans motorisés (3) de protection solaire équipant des ouvertures (2) du bâtiment, le procédé étant **caractérisé en ce qu'**il comprend :
i. Une étape (A1) de modélisation du bâtiment et des ouvertures sur des façades du bâtiment,
ii. Une étape (A3) de détermination itérative des ombres portées par le bâtiment sur lui-même et/ou par les structures environnantes également modélisées en fonction du temps et pour une localisation géographique du bâtiment donnée, l'étape de détermination itérative ayant lieu par incrément de temps sur la totalité d'une année calendaire, la détermination de la présence ou non d'une ombre portée étant rapportée à chaque ouverture,
iii. Une étape (A4) de génération d'un fichier de configuration comprenant des données représentant la présence ou non d'une ombre portée sur chaque ouverture (2) équipée par un écran motorisé de protection solaire en fonction du temps, l'étape de détermination permettant de générer le fichier de configuration au cours d'une étape de calcul, le calcul étant mis en oeuvre par des moyens de calcul,
iv. Une étape (A5) de fourniture du fichier de configuration à l'unité centrale de commande de l'installation.

2. Procédé de configuration selon la revendication 1, **caractérisé en ce que** la modélisation lors de l'étape (i) est une modélisation virtuelle en trois dimensions du bâtiment, incluant la localisation des façades (N1, N2, S1, S2, W1, W2, E1, E2) et le positionnement des ouvertures équipées d'écrans motorisés de protection solaire sur les façades.

3. Procédé de configuration selon l'une des revendications précédentes, **caractérisé en ce qu'**il comprend une étape (A2) de modélisation virtuelle en trois dimensions des structures et reliefs environnants le bâtiment.

4. Procédé de configuration selon l'une des revendications précédentes, **caractérisé en ce que** les données du fichier de configuration sont des données binaires indiquant ou non la présence d'une ombre portée pour une ouverture donnée ou une partie d'ouverture donnée, à un instant donné.

5. Procédé de configuration selon l'une des revendications précédentes, **caractérisé en ce que** l'étape (ii) est réalisée par façade et réitérée pour chaque façade du bâtiment pour lesquelles une information de présence de soleil est fournie.

6. Procédé de configuration selon l'une des revendications précédentes, **caractérisé en ce que** les étapes (ii), (iii), (iv) sont réitérées si un changement est intervenu sur le bâtiment ou sur son environnement nécessitant une mise à jour du fichier de configuration.

7. Procédé de configuration selon l'une des revendications précédentes, **caractérisé en ce que** le fichier de configuration contient des informations relatives à l'ombre portée sur une partie de chaque ouverture.

8. Procédé de configuration selon l'une des revendications précédentes, **caractérisé en ce qu'**il comprend un enregistrement ou un stockage du fichier de configuration sur un support de données (14), notamment dans une mémoire.

9. Procédé de fonctionnement d'une installation (INST) comprenant une unité centrale de commande (10) et des écrans motorisés (3) de protection solaire, **caractérisé en ce que** :
- le procédé de fonctionnement comprend une étape d'utilisation du fichier de configuration généré par mise en oeuvre du procédé de configuration selon l'une des revendications précédentes pour commander les écrans motorisés, notamment une étape d'utilisation d'un fichier de configuration généré par mise en oeuvre du procédé de configuration selon l'une des revendications précédentes et comprenant des données représentant la présence ou non d'ombres portées sur chaque ouverture (2) équipée par un écran motorisé de protection solaire en fonction du temps, ou **en ce que**
- le procédé de fonctionnement comprend :
∘ une étape de génération d'un fichier de configuration comprenant des données représentant la présence ou non d'une ombre portée sur chaque ouverture équipée par un écran motorisé de protection solaire en fonction du temps, comprenant une étape de mise en oeuvre d'un procédé de configuration selon l'une des revendications précédentes, et
∘ une étape d'utilisation du fichier de configuration.

10. Procédé de fonctionnement selon la revendication précédente, **caractérisé en ce que** l'étape d'utilisation du fichier comprend :
i. Une étape (A6) de commande de mouvement de chaque écran motorisé de protection solaire d'une première zone de façade en fonction d'une information de présence de soleil relative à la première zone de façade,
ii. Une étape (A7) d'inhibition de la commande de mouvement de l'étape précédente en fonction des données du fichier de configuration relatives à chaque ouverture de la zone.

11. Procédé de fonctionnement selon la revendication précédente, **caractérisé en ce que** l'étape d'inhibition dépend d'une information de niveau d'ensoleillement.

12. Procédé de fonctionnement selon l'une des revendications 9 à 11, **caractérisé en ce que** les données du fichier de configuration sont fournies sélectivement au cours du temps au niveau d'une entrée d'un actionneur, d'un groupe d'actionneur ou d'un moyen de commande local d'un ou plusieurs actionneurs de manoeuvre d'écran motorisé.

13. Installation (INST) de protection solaire dans un bâtiment (1) muni d'ouvertures, comprenant une unité centrale de commande (10), des écrans motorisés (3) de protection solaire, l'unité centrale de commande étant adaptée à fournir des ordres de commande de mouvement de chaque écran motorisé de protection solaire d'une première zone de façade en fonction d'une information de présence de soleil relative à la première zone de façade et comprenant une mémoire (14) destinée à stocker un fichier de configuration comprenant des données relatives à la présence ou non d'une ombre portée sur chaque ouverture équipée par un écran motorisé de protection solaire en fonction du temps, l'installation comprenant également une entrée correspondant à chaque écran motorisé ou chaque moyen de commande local pilotant un ou plusieurs écrans motorisés et des moyens matériels et/ou logiciels pour inhiber une commande de mouvement reçue par un écran motorisé lorsque la donnée fournie en entrée d'un écran motorisé indique la présence d'une ombre portée sur l'ouverture ou la partie d'ouverture correspondant à cet écran,
le fichier de configuration étant fourni à l'unité centrale de commande de l'installation,
comprenant en outre des moyens pour générer le fichier de configuration au cours d'une étape de calcul, à partir des ombres portées par le bâtiment sur lui-même et/ou par les structures environnantes modélisées en fonction du temps et pour une localisation géographique du bâtiment donnée, les ombres étant
déterminées itérativement,
la détermination itérative ayant lieu par incrément de temps sur la totalité d'une année calendaire,
la détermination de la présence ou non d'une ombre portée étant rapportée à chaque ouverture.

## Patentansprüche

1. Von einem Computer eingesetztes Verfahren zur Konfiguration einer Sonnenschutzanlage (INST) in einem Gebäude (1), wobei die Anlage eine zentrale Steuereinheit (10) zur Bewegung von motorisierten Sonnenschutzschirmen (3), mit denen Öffnungen (2) des Gebäudes ausgestattet sind, umfasst, wobei das Verfahren **dadurch gekennzeichnet ist, dass** es umfasst:
i. Einen Schritt (A1) der Modellierung des Gebäudes und der Öffnungen an den Fassaden des Gebäudes,
ii. Einen Schritt (A3) der iterativen Bestimmung des Schattenwurfs durch das Gebäude auf sich selbst und/oder durch die umgebenden Strukturen, die ebenfalls modelliert werden, in Abhängigkeit von der Zeit und für eine gegebene geografische Lage des Gebäudes, wobei der Schritt der iterativen Bestimmung je Zeitinkrement über ein gesamtes Kalenderjahr erfolgt, wobei die Bestimmung des Vorhandenseins oder Nichtvorhandenseines eines Schattenwurfs auf jede Öffnung bezogen ist,
iii. Einen Schritt (A4) der Erzeugung einer Konfigurationsdatei mit Daten, die das Vorhandensein oder Nichtvorhandensein eines Schattenwurfs auf jede mit einem motorisierten Sonnenschutzschirm ausgestattete Öffnung (2) repräsentieren, wobei der Bestimmungsschritt es ermöglicht, die Konfigurationsdatei während eines Berechnungsschritts zu erzeugen, wobei die Berechnung von Rechenmitteln durchgeführt wird,
iv. Einen Schritt (A5) der Bereitstellung der Konfigurationsdatei für die zentrale Steuereinheit der Anlage.

2. Konfigurationsverfahren nach Anspruch 1, **dadurch gekennzeichnet, dass** die Modellierung im Schritt (i) eine virtuelle dreidimensionale Modellierung des Gebäudes ist, welche die Lage der Fassaden (N1, N2, S1, S2, W1, W2, E1, E2) und die Anordnung der mit motorisierten Sonnenschutzschirmen ausgestatteten Öffnungen an den Fassaden beinhaltet.

3. Konfigurationsverfahren nach einem der vorhergehenden Ansprüche, **dadurch gekennzeichnet, dass** es einen Schritt (A2) der virtuellen dreidimensionalen Modellierung der das Gebäude umgebenden Strukturen und Erhebungen umfasst.

4. Konfigurationsverfahren nach einem der vorhergehenden Ansprüche, **dadurch gekennzeichnet, dass** die Daten der Konfigurationsdatei binäre Daten sind, die das Vorhandensein eines Schattenwurfs für eine gegebene Öffnung oder einen gegebenen Öffnungsteil zu einem gegebenen Zeitpunkt angeben oder nicht.

5. Konfigurationsverfahren nach einem der vorhergehenden Ansprüche, **dadurch gekennzeichnet, dass** der Schritt (ii) je Fassade ausgeführt wird und für jede Fassade des Gebäudes, für die eine Information über das Vorhandensein von Sonne vorliegt, wiederholt wird.

6. Konfigurationsverfahren nach einem der vorhergehenden Ansprüche, **dadurch gekennzeichnet, dass** die Schritte (ii), (iii), (iv) wiederholt werden, wenn eine Änderung am Gebäude oder an seiner Umgebung eingetreten ist, die eine Aktualisierung der Konfigurationsdatei erfordert.

7. Konfigurationsverfahren nach einem der vorhergehenden Ansprüche, **dadurch gekennzeichnet, dass** die Konfigurationsdatei Informationen über den Schattenwurf auf einen Teil jeder Öffnung enthält.

8. Konfigurationsverfahren nach einem der vorhergehenden Ansprüche, **dadurch gekennzeichnet, dass** es eine Aufzeichnung oder eine Speicherung der Konfigurationsdatei auf einem Datenträger (14), insbesondere in einem Speicher, umfasst.

9. Verfahren zum Betreiben einer Anlage (INST), die eine zentrale Steuereinheit (10) und motorisierte Sonnenschutzschirme (3) umfasst, **dadurch gekennzeichnet, dass**:
- das Betriebsverfahren einen Schritt der Verwendung der Konfigurationsdatei, die durch Ausführen des Konfigurationsverfahrens nach einem der vorhergehenden Ansprüche erzeugt wurde, zur Steuerung der motorisierten Schirme umfasst, insbesondere einen Schritt der Verwendung einer Konfigurationsdatei, die durch Ausführen des Konfigurationsverfahrens nach einem der vorhergehenden Ansprüche erzeugt wurde und Daten umfasst, die das Vorhandensein oder Nichtvorhandensein von Schattenwurf auf jede mit einem motorisierten Sonnenschutzschirm ausgestattete Öffnung (2) in Abhängigkeit von der Zeit repräsentieren, oder dadurch, dass
- das Betriebsverfahren umfasst:
• einen Schritt der Erzeugung einer Konfigurationsdatei, die Daten umfasst, die das Vorhandensein oder Nichtvorhandensein eines Schattenwurfs auf jede mit einem motorisierten Sonnenschutzschirm ausgestattete Öffnung in Abhängigkeit von der Zeit repräsentieren, umfassend einen Schritt der Ausführung eines Konfigurationsverfahrens nach einem der vorhergehenden Ansprüche, und
• einen Schritt der Verwendung der Konfigurationsdatei.

10. Betriebsverfahren nach dem vorhergehenden Anspruch, **dadurch gekennzeichnet, dass** der Schritt der Verwendung der Datei umfasst:
i. Einen Schritt (A6) der Steuerung der Bewegung jedes motorisierten Sonnenschutzschirms eines ersten Fassadenbereichs in Abhängigkeit von einer Information über das Vorhandensein von Sonne für den ersten Fassadenbereich,
ii. Einen Schritt (A7) der Blockierung der Bewegungssteuerung des vorhergehenden Schritts in Abhängigkeit von den Daten der Konfigurationsdatei für jede Öffnung des Bereichs.

11. Betriebsverfahren nach dem vorhergehenden Anspruch, **dadurch gekennzeichnet, dass** der Schritt der Blockierung von einer Information über die Stärke der Sonneneinstrahlung abhängt.

12. Betriebsverfahren nach einem der Ansprüche 9 bis 11, **dadurch gekennzeichnet, dass** die Daten der Konfigurationsdatei im Laufe der Zeit selektiv an einem Eingang eines Antriebs oder einer Gruppe von Antrieben oder eines lokalen Steuerungsmittel eines oder mehrerer Antriebe zur Betätigung eines motorisierten Schirms bereitgestellt werden.

13. Sonnenschutzanlage (INST) in einem Gebäude (1), das mit Öffnungen versehen ist, umfassend eine zentrale Steuereinheit (10), motorisierte Sonnenschutzschirme (3), wobei die zentrale Steuereinheit geeignet ist, Befehle zum Steuern der Bewegung jedes motorisierten Sonnenschutzschirms eines ersten Fassadenbereichs in Abhängigkeit von einer Information über das Vorhandensein von Sonne für den ersten Fassadenbereich bereitzustellen, und umfassend einen Speicher (14), der dazu bestimmt ist, eine Konfigurationsdatei zu speichern, die Daten zum Vorhandensein oder Nichtvorhandensein eines Schattenwurfs auf jede mit einem motorisierten Sonnenschutzschirm ausgestattete Öffnung in Abhängigkeit von der Zeit umfasst, wobei die Anlage auch einen Eingang umfasst, der jedem motorisierten Schirm oder jedem lokalen Steuerungsmittel zur Ansteuerung eines oder mehrerer motorisierter Schirme entspricht, und Hardware- und/oder Softwaremittel, um einen von einem motorisierten Schirm empfangenen Bewegungsbefehl zu blockieren, wenn der im Eingang eines motorisierten Schirms bereitgestellte Datenwert das Vorhandensein eines Schattenwurfs auf die Öffnung oder den Öffnungsteil, der diesem Schirm entspricht, anzeigt,
wobei die Konfigurationsdatei der zentralen Steuereinheit der Anlage bereitgestellt wird, umfassend ferner Mittel zum Erzeugen der Konfigurationsdatei während eines Rechenschritts ausgehend von den Schattenwürfen durch das Gebäude auf sich selbst und/oder durch die umgebenden Strukturen, die in Abhängigkeit von der Zeit und für eine gegebene geografische Lage des Gebäudes modelliert sind, wobei die Schatten iterativ bestimmt werden,
wobei die iterative Bestimmung je Zeitinkrement über ein gesamtes Kalenderjahr erfolgt,
wobei die Bestimmung des Vorhandenseins oder Nichtvorhandenseines eines Schattenwurfs auf jede Öffnung bezogen ist.

## Claims

1. Method for configuring a solar protection installation (INST) in a building (1), the method being implemented by computer, the installation comprising a central unit (10) for controlling movements of motorized solar protection screens (3) with which openings (2) of the building are equipped, the method being **characterized in that** it comprises:
i. a step (A1) of modelling the building and the openings on façades of the building,
ii. a step (A3) of iteratively determining shadows cast by the building on itself and/or by surrounding structures also modelled as a function of time and for a given geographic location of the building, the iterative determination step taking place by time increment over an entire calendar year, the determination of the presence or non-presence of a cast shadow being relative to each opening,
iii. a step (A4) of generating a configuration file comprising data representing the presence or not of a shadow cast on each opening (2) equipped with a motorized solar protection screen as a function of time, the determination step permitting to generate the configuration file during a computation step, the computation being implemented by computation means,
iv. a step (A5) of supplying the configuration file to the central control unit of the installation.

2. Configuration method according to Claim 1, **characterized in that** the modelling in the step (i) is a three-dimensional virtual modelling of the building, including the location of the façades (N1, N2, S1, S2, W1, W2, E1, E2) and the positioning of the openings equipped with motorized solar protection screens on the façades.

3. Configuration method according to one of the preceding claims, **characterized in that** it comprises a step (A2) of three-dimensional virtual modelling of the structures and reliefs surrounding the building.

4. Configuration method according to one of the preceding claims, **characterized in that** the configuration file data are binary data indicating or not indicating the presence of a shadow cast for a given opening or a given part of opening, at a given instant.

5. Configuration method according to one of the preceding claims, **characterized in that** the step (ii) is performed for each façade and reiterated for each façade of the building for which a sun presence indication is supplied.

6. Configuration method according to one of the preceding claims, **characterized in that** the steps (ii), (iii), (iv) are reiterated if a change occurs on the building or on its environment necessitating an update of the configuration file.

7. Configuration method according to one of the preceding claims, **characterized in that** the configuration file contains information relating to the shadow cast on a part of each opening.

8. Configuration method according to one of the preceding claims, **characterized in that** it comprises a recording or a storage of the configuration file on a data carrier (14), notably in a memory.

9. Method for operating an installation (INST) comprising a central control unit (10) and motorized solar protection screens (3), **characterized in that**:
- the operating method comprises a step of use of the configuration file generated by using the configuration method according to one of the preceding claims to control the motorized screens, notably a step of using a configuration file generated by implementing the configuration method according to one of the preceding claims and comprising data representing the presence or not of shadows cast on each opening (2) equipped with a motorized solar protection screen as a function of time, or **in that**
- the operating method comprises:
• a step of generating a configuration file comprising data representing the presence or not of a shadow cast on each opening equipped with a motorized solar protection screen as a function of time, comprising a step of implementing the configuration method according to one of the preceding claims, and
• a step of using the configuration file.

10. Operating method according to the preceding claim, **characterized in that** the step of using the file comprises:
i. a step (A6) of commanding a movement of each motorized solar protection screen of a first façade area as a function of a sun presence indication relating to the first façade area,
ii. a step (A7) of disabling the command of movement of the preceding step as a function of the configuration file data relating to each opening of the area.

11. Operating method according to the preceding claim, **characterized in that** the disabling step depends on a sunlight level indication.

12. Operating method according to one of Claims 9 to 11, **characterized in that** the configuration file data are supplied selectively over time at an input of an actuator, of an actuator group or of a local control means for one or more motorized screen manoeuvre actuators.

13. Solar protection installation (INST) in a building (1) provided with openings, comprising a central control unit (10), motorized solar protection screens (3), the central control unit being suitable for supplying movement control commands for each motorized solar protection screen of a first façade area as a function of a sun presence indication relating to the first façade area and comprising a memory (14) intended to store a configuration file comprising data relating to the presence or not of a shadow cast on each opening equipped with a motorized solar protection screen as a function of time, the installation also comprising an input corresponding to each motorized screen or each local control means driving one or more motorized screens and hardware and/or software means for disabling a movement command received by a motorized screen when the data supplied as input for a motorized screen indicates the presence of a shadow cast on the opening or the part of opening corresponding to this screen,
the configuration file being provided to the central control unit of the installation,
the installation comprising means for generating the configuration file during a computation step, from shadows cast by the building on itself and/or by surrounding structures modelled as a function of time and for a given geographic location of the building,
the shadows being determined iteratively,
the iterative determination taking place by time increment over an entire calendar year,
the determination of the presence or non-presence of a cast shadow being relative to each opening.
